# EUROPEAN PATENT SPECIFICATION

(11) **EP 0 632 385 B1**
(45) Date of publication and mention of the grant of the patent: **04.11.1998**
(21) Application number: 94109636.4
(22) Date of filing: 22.06.1994
(51) Int. Cl.: G06F 11/26

(54) **Semiconductor integrated circuit including test circuit**
Integrierte Halbleiterschaltung mit Prüfschaltung
Circuit intégré semi-conducteur avec circuit de test

(30) Priority: 22.06.1993 JP 150432/93
(43) Date of publication of application: 04.01.1995
(73) Proprietor: KABUSHIKI KAISHA TOSHIBA, Kawasaki-shi (JP)
(72) Inventor: Saeki, Yukihiro, c/o Intellectual Property Div., Minato-ku, Tokyo 105 (JP)
(74) Representative: Lehn, Werner, Dipl.-Ing.

(56) References cited:
- US-A- 5 083 083

## Description

The present invention relates to a semiconductor integrated circuit which includes a test circuit for testing whether or not the wiring lines of the semiconductor integrated circuit work normally.

Before an integrated circuit is shipped from a factory, it must be guaranteed that the integrated circuit does not have any defect. In order to confirm that the integrated circuit has no defect, it is necessary to check the integrated circuit by means of a test apparatus.

An integrated circuit is fabricated to attain a certain function, and the test apparatus tests whether or not the fabricated integrated circuit can attain it. The integrated circuit is shipped after the test shows that the integrated circuit does not have any problem.

Integrated circuits developed in recent years are very large in scale, and the functions which have to be attained by use of a single chip are very complex. Since the integrated circuits have to be tested in a large number of points to confirm their functions, the test requires a very long time, resulting in a delay in the shipment of the integrated circuits. In addition, a great expense is required for the test.

In order to make the test easily and quickly, an integrated circuit recently developed incorporates not only circuit elements for attaining the required functions but also test circuits for testing the functions of the integrated circuit. Although a variety of test circuits are provided in accordance with purposes, a test circuit used for checking the wiring lines of a microcomputer will be briefly described by way of an example.

A comparatively long wiring line, which is generally referred to as a data bus, is incorporated in a semiconductor chip constituting a microcomputer. The circuit elements of the microcomputer exchange data through the data bus.

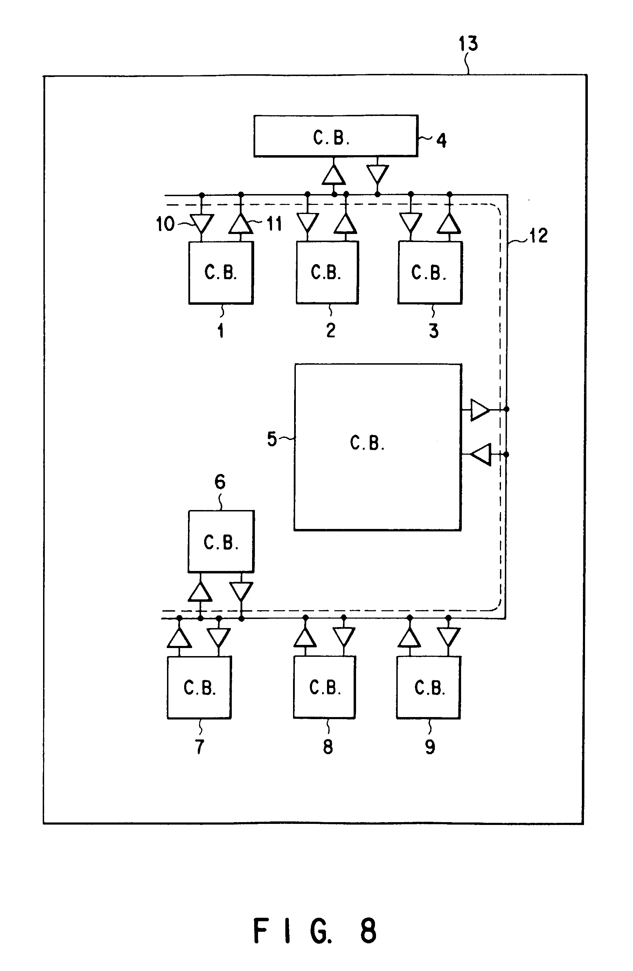

FIG. 8 shows a conventional microcomputer and depicts one data bus 12. Referring to FIG. 8, circuit blocks 1-9, each made up of various circuits, are arranged on a semiconductor chip 13. Each of the circuit blocks (C.B.) 1-9 is connected to the data bus 12 by way of an input buffer 10 and an output buffer 11. To check whether or not the data bus 12 has an electrical disconnection, the conventional art transfers data from circuit block 1 connected at one end of the data bus 12 toward circuit block 7 connected at the other end of the data bus 12. Then, the conventional art compares the data transmitted from circuit block 1 with the data received by circuit block 7. When these two data are identical to each other, it is determined that the data bus 12 does not have any electrical disconnection.

In the conventional art, however, a complex operation is required for checking the data bus 12. To be more specific, the data bus 12 is checked by the following procedures: setting the data in circuit block 1; transferring the data from circuit block 1 toward circuit block 7; and comparing the data received by circuit block 7 with the data set in circuit block 1. Since these testing procedures are complex, the conventional art inevitably requires a long test time.

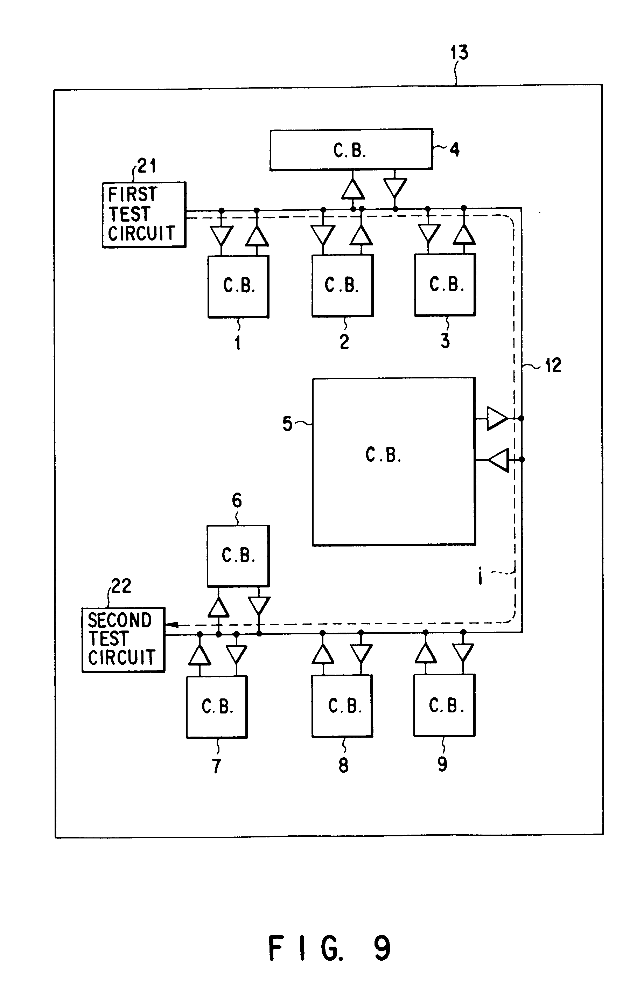

FIG. 9 shows another example of a conventional test circuit. In FIG. 9, the same reference numbers as used in FIG. 8 denote structural elements corresponding to those shown in FIG. 8. Referring to FIG. 9, a first test circuit 21 is connected to one end of a data bus 12, and a second test circuit 22 is connected to the other end of the data bus 12. The first and second test circuits do not perform any particular operation when the semiconductor chip 13 is in a normal operation mode. In a test mode, however, the first test circuit 21 has a function of supplying a current to the second test circuit 22 by way of the data bus 12. The second test circuit 21 incorporates a sense amplifier (not shown) used for detecting a current supplied from the first test circuit 21. If the data bus 12 has an electrical disconnection, no current flows from the first test circuit 21 to the second test circuit 22. It is therefore possible to easily check whether or not the data bus 12 has an electrical disconnection. With this circuit configuration, an electrical disconnection of a wiring line can be easily checked, with no need to provide the circuit blocks 1 and 7 mentioned above.

However, in the circuit configuration mentioned above, the first and second test circuits 21 and 22 are connected to the respective ends of one wiring line. Therefore, the integration density of the semiconductor chip is adversely affected. In addition, since a large number of signals are required for controlling the test circuits, the testing method is inevitably complex.

A method for performing the above current conduction test in a simpler way is disclosed in U.S. Patent No. 4,857,774. According to this U.S. Patent, a large number of wiring lines are connected in series and are checked at one time to detect whether they have an electrical disconnection.

FIG. 10 is a schematic diagram of the circuit disclosed in U.S. Patent No. 4,857,774. Referring to FIG. 10, a first test circuit 21 is connected to one end of a data bus 12 by way of a wiring line 30 and a switch 31, and a second test circuit 22 is connected to the other end of the data bus 12. In this case, not only the data bus 12 but also the wiring line 30 is checked. The switch 31 is kept OFF in the normal operation mode of the semiconductor chip 13, and is turned on in a test mode in which an electrical disconnection is detected. In the test mode, therefore, the wiring line 30 and the data bus 12 are electrically connected together and can be regarded as constituting a single signal line. In this state, a current is supplied from the first test circuit 21 toward the second test circuit 22 by way of the wiring line 30, the switch 31, and the data bus 12. When the current supplied from the first test circuit 21 is sensed by the second test circuit 22, it is determined that neither the wiring line 30 nor the data bus 12 has an electrical disconnection. Conversely, when the current supplied from the first test circuit 21 is not sensed by the second test circuit 22, it is determined that at least one of the wiring line 30 and data bus 12 has an electrical disconnection.

A large number of wiring lines can be checked at one time in a similar manner. To be specific, switches are provided between the adjacent ones of the wiring lines, and these switches are turned on only when a test is made. This configuration contributes to a reduction in the number of test circuits required, and does not adversely affect the density of integration.

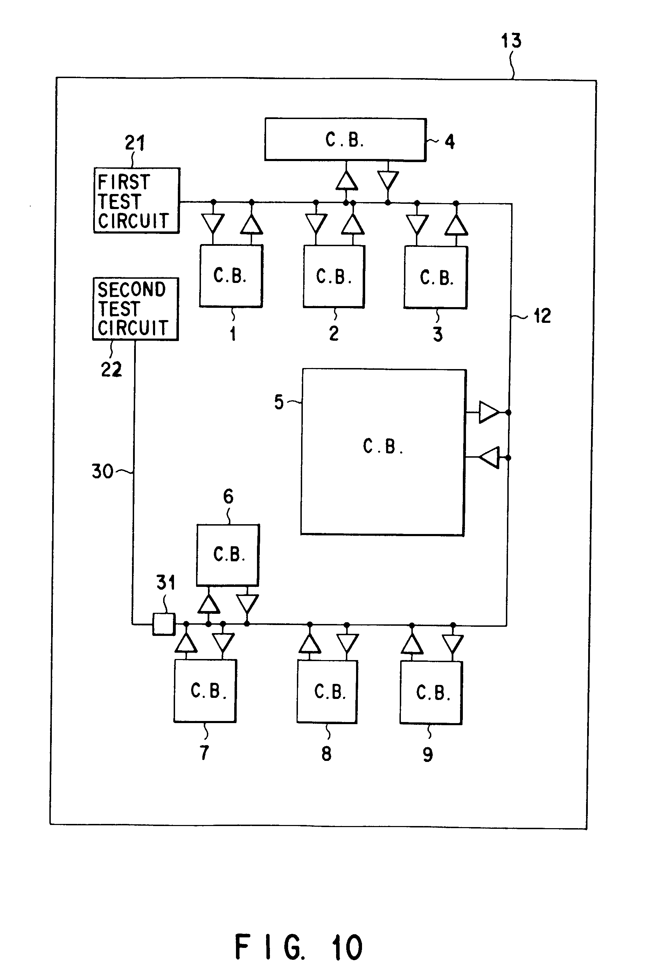

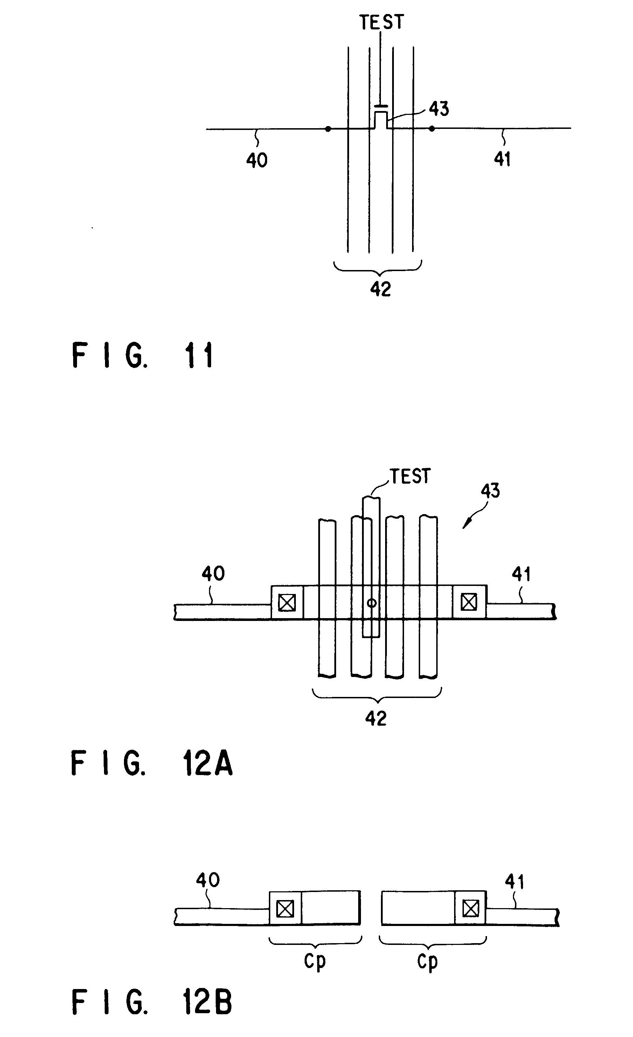

However, the conventional art shown in FIG. 10 will have a problem if the two wiring lines to be connected together by means of a switch are located away from each other. For example, a pattern wherein column-direction wiring lines 42 extend between two row-direction wiring lines 40 and 41, as shown in FIG. 11, is very general in the art. In the pattern shown in FIG. 11, wiring lines 40 and 41 are connected together by means of a single N-channel MOS transistor 43 (a switching element) which is located below wiring lines 42. The transistor 43 is controlled by a gate control signal TEST. In the test mode, the logical level of the gate control signal TEST is set to be "1", and the transistor 43 is turned on in response to this gate control signal. As a result, the wiring lines 40 and 41 are connected together. In the normal operation mode, the logical level of the gate control signal TEST is set to be "0", and the transistor 43 is turned off in response to this gate control signal. As a result, the wiring lines 40 and 41 are electrically disconnected from each other.

FIG. 12A shows a pattern layout corresponding to FIG. 11. As is shown in FIG. 12A, the source of the transistor 43 mentioned above is connected to wiring line 40, and the drain thereof is connected to wiring line 41. Since this transistor is kept off in the normal operation mode, it follows that large capacitors Cp made up of the source or drain are connected to the wiring lines 40 and 41, as shown in FIG. 12B. The capacitance of the capacitors Cp increases with an increase in the distance between the wiring lines 40 and 41. In the normal operation mode, therefore, the signal transmission speed of the wiring lines is greatly lowered by the transistor 43. It should be noted that the test circuits are totally unnecessary in the normal operation mode. Although they are provided for the purpose of simplifying the testing procedures, they undesirably affect the characteristics of the integrated circuit after the test is made.

The object of the present invention is to provide a test circuit which can reliably test a semiconductor integrated circuit, can suppress adverse effects on the normal operation mode of the semiconductor integrated circuit, particularly the adverse effects on the signal transmission speed of wiring lines, and can prevent a deterioration in the characteristics of the semiconductor integrated circuit.

The present invention provides, in common with the semiconductor integrated circuit with integral test circuit according to Figure 11, a semiconductor integrated circuit including a test circuit therefor, comprising a first wiring line, a second wiring line, a first test circuit, connected to one end of the first wiring line, for outputting a current when a test is made, a second test circuit connected to one end of the second wiring line, and a switch connected between the other end of the first wiring line and the other end of the second wiring line, said switch being settable in a conductive state when the test is made, thereby permitting the current, output from the first test circuit and flowing through the first wiring line, to be supplied to the second test circuit by way of the second wiring line, said second test circuit being arranged for detecting a current supplied thereto through the second wiring line when the test is made, characterised in that said switch comprises a plurality of transistors having current paths which are connected in series.

In the semiconductor integrated circuit with integral test circuit, a plurality of transistors are arranged between the first and second wiring lines such that the current paths of the transistors are connected in series. When a test is made, the transistors are turned on to electrically connect the first and second wiring lines together, and a testing current is supplied from the first test circuit toward the second test circuit by way of the wiring lines and the transistors. Although the transistors are turned off in the normal operation mode, the capacitance between the first and second wiring lines is small due to the use of a plurality of transistors. Hence, the operation speed of the integrated circuit is not adversely affected.

This invention can be more fully understood from the following detailed description, given by way of example, when taken in conjunction with the accompanying drawings, in which:
FIG. 1 is a circuit diagram showing one embodiment of the present invention;
FIG. 2 is a planar pattern view showing the major portion of the circuit depicted in FIG. 1;
FIG. 3 is a plan view showing how the circuit depicted in FIGS. 1 and 2 operates;
FIG. 4 is a circuit diagram showing the second embodiment of the present invention;
FIG. 5 is a circuit diagram showing the third embodiment of the present invention;
FIG. 6 shows how the circuit depicted in FIG. 5 operates;
FIG. 7 is a circuit diagram showing the fourth embodiment of the present invention;
FIG. 8 is a circuit diagram showing one example of a conventional test circuit;
FIG. 9 is a circuit diagram showing another example of a conventional test circuit;
FIG. 10 is a circuit diagram showing still another example of a conventional test circuit;
FIG. 11 is a circuit diagram showing the major portion of a conventional test circuit;
FIG. 12A is a plan view showing the pattern layout of the major portion depicted in FIG. 11; and
FIG. 12B is a plan view showing the state where the transistor depicted in FIG. 12A is in the OFF state.

Embodiments of the present invention will be described with reference to the accompanying drawings.

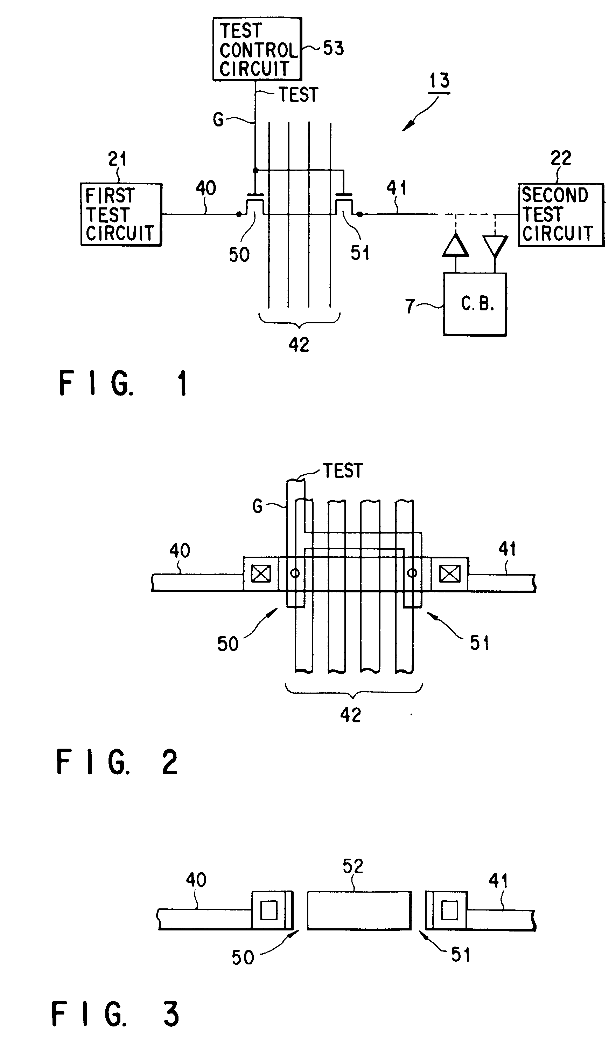

Referring to FIGS. 1 and 2, a first test circuit 21 is connected to one end of a wiring line 40, and a second test circuit 22 is connected to one end of another wiring line 41 (which serves as a data bus). Circuit elements are connected to the wiring line 41. N-channel MOS transistors 50 and 51, which are connected in series, are provided between the two wiring lines 40 and 41 and located below wiring lines 42. In other words, MOS transistors 50 and 51 are formed in a semiconductor substrate (not shown). An insulating layer (not shown) is formed on the MOS transistors 50 and 51, and the wiring lines 42 are located on the insulating layer. One end (source) of the current path of transistor 50 is connected to the other end of wiring line 40, and the other end (drain) thereof is connected to one end (source) of the current path of transistor 51. The other end (drain) of the current path of transistor 51 is connected to the other end of wiring line 41. The gates G of the transistors 50 and 51 are connected to a test control circuit 53 and receive a gate control signal TEST output from the test control circuit 53.

In the above circuit configuration, the logical level of the gate control signal TEST is set to be "1" when a test is made. Therefore, the transistors 50 and 51 are simultaneously turned on, and the wiring lines 40 and 41 are electrically connected together by means of the transistors 50 and 51. In this state, a current is supplied from the first test circuit 21 toward the second test circuit 22 through the wiring lines 40 and 41 and transistors 50 and 51. The second test circuit 22 senses the current supplied thereto, so as to determine whether the wiring lines 40 and 41 have an electrical disconnection.

In the normal operation mode, the logical level of the gate control signal TEST is set to be "0". Therefore, the transistors 50 and 51 are turned off. The transistors 50 and 51 in this state are shown in FIG. 3. As is shown in FIG. 3, the capacitance of a source/drain region 52, which is cut off by the channel portions of the transistors 50 and 51, is isolated from the wiring lines 40 and 41. Therefore, both the capacitance of the source of transistor 50 and that of the drain of transistor 51 can be greatly reduced. When the transistors 50 and 51 are OFF, only the capacitance of the source/drain region 52 increases, and the capacitance connected to the wiring lines 40 and 41 does not increase. This holds true even of the case where the wiring lines 40 and 41 are very away from each other. In the normal operation mode, therefore, the operation speed of the integrated circuit is not adversely affected, and a large amount of current is prevented from being used in vain. In addition, the characteristic deterioration of the integrated circuit can be a minimum.

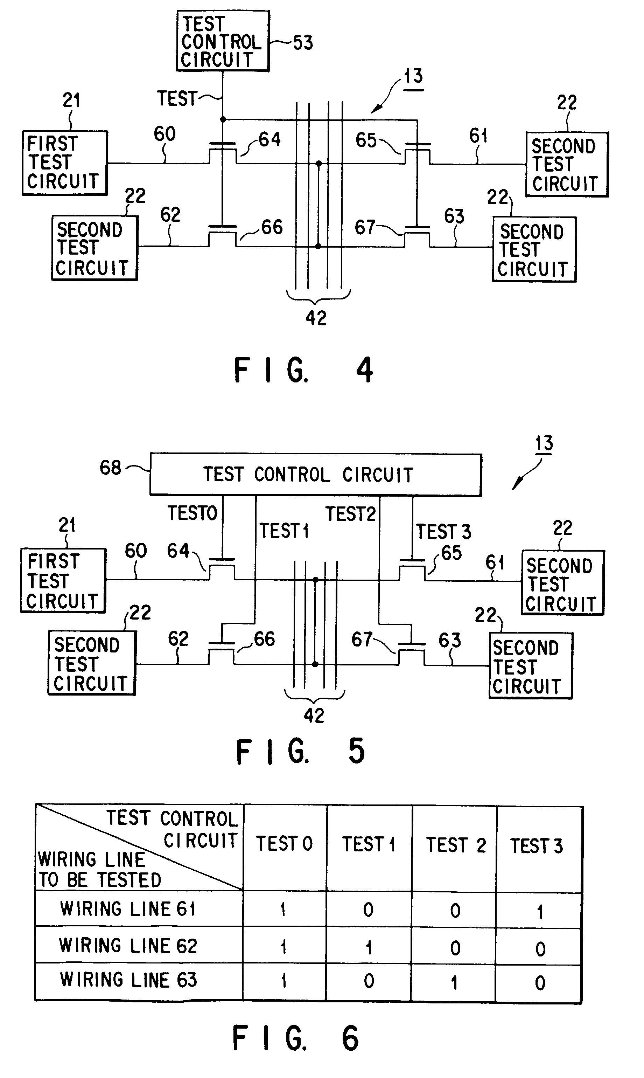

FIG. 4 shows the second embodiment of the present invention. In the second embodiment, two wiring lines, arbitrarily selected from four wiring lines, can be tested to check whether they have an electrical disconnection. Referring to FIG. 4, a first test circuit 21 is connected to one end of a wiring line 60, and a current is supplied from the first test circuit 21 to wiring line 60. A second test circuit 22 is connected to one end of each of other wiring lines 61-63 (which serve as data buses). Circuit elements (not shown) are connected to each of wiring lines 61-63. The second test circuit 22 senses a current supplied thereto through the corresponding wiring line. N-channel MOS transistors 64 and 65, which are connected in series, are provided between wiring lines 60 and 61 and located above wiring lines 42. Likewise, N-channel MOS transistors 66 and 67, which are connected in series, are provided between wiring lines 62 and 63 and located below wiring lines 42. One end (source) of the current path of transistor 64 is connected to the other end of wiring line 60, and the other end (drain) thereof is connected to one end (source) of the current path of each of transistors 65, 66 and 67. The other ends (drains) of the current paths of transistors 65, 66 and 67 are connected to the other ends of wiring lines 61, 62 and 63, respectively. The gates G of the transistors 64-67 are connected to a test control circuit 53 and receive a gate control signal TEST output from the test control circuit 53.

In the above circuit configuration, the logical level of the gate control signal TEST is set to be "1" when a test is made. Therefore, the transistors 64-67 are simultaneously turned on. In this state, a current is supplied from the first test circuit 21 to the wiring lines 61-63 by way of the transistors 64-67. Each second test circuit 22 senses the current supplied thereto through the corresponding wiring line, so as to determine whether the corresponding wiring line has an electrical disconnection. It should be noted that the second test circuits 22 may be operated at the same time or at different times. In the normal operation mode, the logical level of the gate control signal TEST is set to be "0". Therefore, all the transistors 64-67 are turned off, and wiring lines 61-63 are electrically disconnected from wiring line 60. In this case, however, the capacitance of each of wiring lines 61-64 does not increase, as can be understood from the explanation made with reference to the first embodiment.

In the above description of the second embodiment, reference was made to the case where four wiring lines are tested. Needless to say, however, the number of wiring lines tested is not limited to four, and an arbitrary number of wiring lines can be tested in the second embodiment.

In the second embodiment, the gates of the transistors 64-67 are connected in common to the same output terminal of the test control circuit 53. However, as long as all the transistors 64-67 can be turned off in the normal operation mode, they may be selectively turned on in the test mode in accordance with the purpose of the test.

FIG. 5 shows the third embodiment of the present invention. The third embodiment differs from the foregoing embodiments in that transistors 64-67 are selectively turned on. In FIG. 5, the structural elements corresponding to those shown in FIG. 4 are denoted by the same reference as used in FIG. 4. In the case of the third embodiment, the gates of transistors 64-67 are connected to different output terminals of a test control circuit 68, and different gate control signals TEST0 to TEST3 are produced from the output terminals. Thus, gate control signals TEST0, TEST1, TEST2 and TEST3 are supplied to the gates of transistors 64, 66, 67 and 65, respectively. In order to check the state of wiring lines 61-63 one by one, the gate control signals TEST0-TEST3 shown in FIG. 6 are output from the test control circuit 68. With the ON/OFF states of the transistors 64-67 being selectively controlled in this manner, the state of an arbitrarily-selected wiring line or lines can be checked.

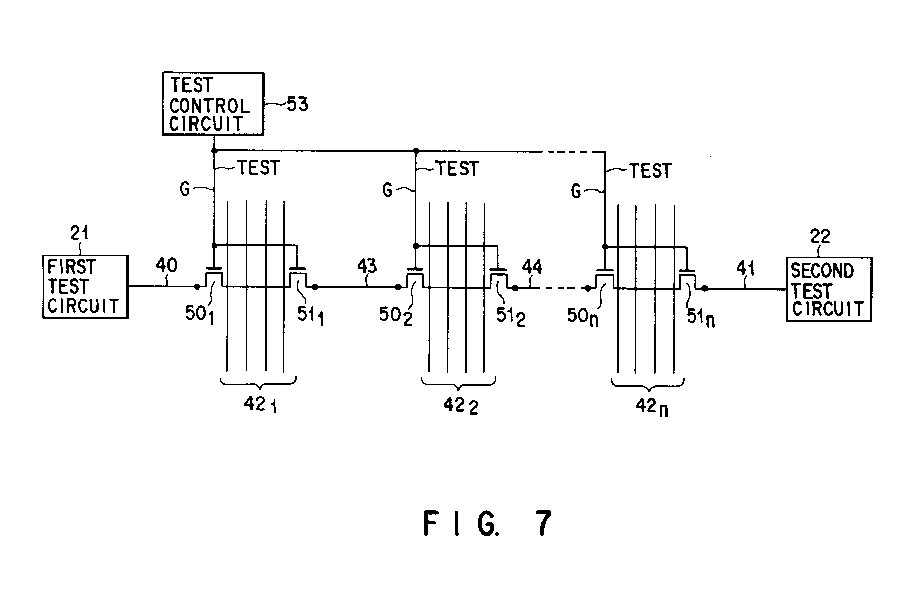

FIG. 7 shows the fourth embodiment of the present invention. This embodiment is a modification of the first embodiment. In FIG. 7, the same reference symbols as used in FIG. 1 are used to denote the corresponding or similar structural elements. Referring to FIG. 7, wiring lines 43 and 44 are arranged between wiring line 40 and wiring line 41. MOS transistors 50₁ and 51₁ are located between wiring line 40 and wiring line 43 and are connected in series to each other, and MOS transistors 50₂ and 51₂ are located between wiring line 43 and wiring line 44 and are connected in series to each other. Likewise, MOS transistors 50ₙ and 51ₙ are located between wiring line 44 and wiring line 41 and are connected in series to each other. The gates of the MOS transistors 50₁ to 51ₙ are connected to a test control circuit 53. Wiring lines 42₁ extend in the region above MOS transistors 50₁ and 51₁, and wiring lines 42₂ extend in the region above MOS transistors 50₂ and 51₂. Likewise, wiring lines 42ₙ extend in the region above MOS transistors 50ₙ and 51ₙ.

With the above circuit configuration, all MOS transistors 50₁ to 50ₙ are simultaneously set in the conductive state in response to a gate control signal TEST output from the test control circuit 53. Therefore, wiring lines 43 and 44 located between wiring line 40 and wiring line 41 can be checked, together with wiring lines 40 and 41.

## Claims

1. A semiconductor integrated circuit including a test circuit therefor, comprising:
a first wiring line (40);
a second wiring line (41);
a first test circuit (21), connected to one end of the first wiring line, for outputting a current when a test is made;
a second test circuit (22) connected to one end of the second wiring line; and
a switch connected between the other end of the first wiring line and the other end of the second wiring line, said switch being settable in a conductive state when the test is made, thereby permitting the current, output from the first test circuit and flowing through the first wiring line, to be supplied to the second test circuit by way of the second wiring line,
said second test circuit being arranged for detecting a current supplied thereto through the second wiring line when the test is made;
characterised in that said switch comprises a plurality of transistors (50, 51) having current paths which are connected in series.

2. A circuit according to Claim 1, characterized in that said transistors (50,51) are located below a third wiring line (42).

3. A circuit according to Claim 2, characterized in that said third wiring line (42) is located between said another end of the first wiring line and said another end of the second wiring line.

4. A circuit according to Claim 1, characterized in that said second wiring line (41) is a data bus to which circuit elements are connected.

5. A circuit according to Claim 1, characterized in that said first and second wiring lines (40,41) have a small capacitance when the transistors are set in an OFF state.

6. A circuit according to Claim 1, characterized in that said first wiring line (40) is connected to a plurality of second wiring lines by means of a plurality of transistors, and when the test is made, at least two of the transistors are set in an ON state, thereby permitting the first wiring line to be electrically connected to the second wiring lines.

## Patentansprüche

1. Integrierte Halbleiterschaltung mit einer Testschaltung hierfür, enthaltend:
eine erste Verdrahtungsleitung (40);
eine zweite Verdrahtungsleitung (41);
eine mit einem Ende der ersten Verdrahtungsleitung verbundene erste Testschaltung (21) zum Ausgeben eines Stroms bei Durchführung eines Tests;
eine mit einem Ende der zweiten Verdrahtungsleitung verbundene zweite Testschaltung (22); und
einen zwischen dem anderen Ende der ersten Verdrahtungsleitung und dem anderen Ende der zweiten Verdrahtungsleitung angeschlossenen Schalter, derart, daß der Schalter bei Durchführung des Tests in einen leitenden Zustand setzbar ist, wodurch der von der ersten Testschaltung ausgegebene und durch die erste Verdrahtungsleitung fließende Strom der zweiten Testschaltung mittels der zweiten Verdrahtungsleitung zugeführt werden kann,
die zweite Testschaltung zum Detektieren eines dieser durch die zweite Verdrahtungsleitung bei Durchführung des Tests zugeführten Stroms ausgebildet ist;
**dadurch gekennzeichnet, daß**
der Schalter mehrere Transistoren (50, 51) mit seriell verbundenen Strompfaden enthält.

2. Schaltung nach Anspruch 1, dadurch gekennzeichnet, daß die Transistoren (50, 51) unterhalb einer dritten Verdrahtungsleitung (42) angeordnet sind.

3. Schaltung nach Anspruch 2, dadurch gekennzeichnet, daß die dritte Verdrahtungsleitung (42) zwischen dem anderen Ende der ersten Verdrahtungsleitung und dem anderen Ende der zweiten Verdrahtungsleitung angeordnet ist.

4. Schaltung nach Anspruch 1, dadurch gekennzeichnet, daß die zweite Verdrahtungsleitung (41) ein Datenbus ist, an dem Schaltungselemente angeschlossen sind.

5. Schaltung nach Anspruch 1, dadurch gekennzeichnet, daß die erste und zweite Verdrahtungsleitung (40, 41) einen geringen Kapazitätswert dann aufweist, wenn die Transistoren in den AUS-Zustand gesetzt sind.

6. Schaltung nach Anspruch 1, dadurch gekennzeichnet, daß die erste Verdrahtungsleitung (40) mit mehreren zweiten Verdrahtungsleitungen mittels mehrerer Transistoren verbunden ist, und daß bei Durchführung des Tests mindestens zwei der Transistoren in einen AN-Zustand gesetzt sind, wodurch die elektrische Verbindung der ersten Verdrahtungsleitung mit den zweiten Verdrahtungsleitungen ermöglicht ist.

## Revendications

1. Circuit intégré semi-conducteur comprenant un circuit de test associé, comprenant :
une première ligne de conducteur (40) ;
une seconde ligne de conducteur (41) ;
un premier circuit de test (21), raccordé à une extrémité de la première ligne de conducteur, pour fournir un courant lorsqu'un test est effectué ;
un second circuit de test (22) raccordé à une extrémité de la seconde ligne de conducteur ; et
un commutateur raccordé entre l'autre extrémité de la première ligne de conducteur et l'autre extrémité de la seconde ligne de conducteur, ledit commutateur étant réglable dans un état conducteur lorsque le test est effectué, permettant ainsi au courant, fourni par le premier circuit de test et passant via la première ligne de conducteur, d'être fourni au second circuit de test au moyen de la seconde ligne de conducteur,
ledit second circuit de test étant disposé pour détecter un courant fourni à celui-ci via la seconde ligne de conducteur lorsque le test est effectué ;
caractérisé en ce que ledit commutateur comprend une pluralité de transistors (50, 51) ayant des chemins de courant qui sont montés en série.

2. Circuit selon la revendication 1, caractérisé en ce que lesdits transistors (50, 51) sont situés sous une troisième ligne de conducteur (42).

3. Circuit selon la revendication 2, caractérisé en ce que ladite troisième ligne de conducteur (42) est située entre ladite autre extrémité de la première ligne de conducteur et ladite autre extrémité de la seconde ligne de conducteur.

4. Circuit selon la revendication 1, caractérisé en ce que ladite seconde ligne de conducteur (41) est un bus de données auquel des éléments de circuit sont raccordés.

5. Circuit selon la revendication 1, caractérisé en ce que lesdites première et seconde lignes de conducteur (40, 41) ont une petite capacité lorsque les transistors sont mis dans l'état bloqué.

6. Circuit selon la revendication 1, caractérisé en ce que ladite première ligne de conducteur (40) est raccordée à une pluralité de secondes lignes de conducteur au moyen d'une pluralité de transistors, et lorsque le test est effectué, au moins deux des transistors sont mis dans un état conducteur, permettant ainsi de raccorder électriquement la première ligne de conducteur aux secondes lignes de conducteur.
